Europäisches Patentamt

European Patent Office

Office européen des brevets

(19)

(11) Publication number: **0 362 418**

**A1**

(12) **EUROPEAN PATENT APPLICATION**

(21) Application number: **88116352.1**

(51) Int. Cl.5: **H01L 21/00 , H01J 37/20**

(22) Date of filing: **03.10.88**

(43) Date of publication of application:
**11.04.90 Bulletin 90/15**

(84) Designated Contracting States:
**DE FR GB**

(71) Applicant: **International Business Machines Corporation**
**Old Orchard Road**
**Armonk, N.Y. 10504(US)**

(72) Inventor: **Dietrich, Hans-Peter**
**Eggstrasse 9**
**CH-8134 Adliswil(CH)**
Inventor: **Ott, Hanspeter**
**Alte Landstrasse 22**
**CH-8800 Thalwil(CH)**
Inventor: **Webb, David John**
**Müllerstrasse 4**
**CH-8803 Rüschlikon(CH)**

(74) Representative: **EGLI-EUROPEAN PATENT ATTORNEYS**
**Horneggstrasse 4**
**CH-8008 Zürich(CH)**

(54) **Improved method and system for the angled exposition of a surface portion to an emission impinging obliquely thereon, and semiconductor wafers having facets exposed according to said method.**

(57) While the substrate (1) is continuously exposed to emission impinging obliquely thereon, it is moved together with the substrate holder (5) so as to maintain its orientation with respect to the source in order to improve the uniformity of the surface properties obtained. Specifically, it is displaced in translation only while made to continuously follow a plane closed path.

In the improved device for moving the substrate holder (5), first shaft (11) is supported at and journalled in base element (10) of the system. Supporting structure (14) is fixedly supported at shaft (11). Second shaft (15) is supported at and journalled in supporting structure (14) parallel to shaft (11) and has the substrate holder (5) affixed thereto. First wheel (16) is supported at base element (10) coaxial to shaft (11). Stop means (18,19) maintain wheel (16) in a predetermined angular position with respect to base element (10). Second wheel (20) is fixedly

supported at shaft (15) coaxial thereto. Means (21,22) are provided for coupling together the wheels (16,20) for imparting to shaft (15) a rotation opposite to the rotation of shaft (11). In an exemplary instance, the wheels (16,20) and the coupling means (21,22) are comprised of gear-wheels.

FIG. 3

# Improved method and system for the angled exposition of a surface portion to an emission impinging obliquely thereon, and semiconductor wafers having facets exposed according to said method

The present invention relates to an improved method for the angled exposition of at least one surface portion of a substrate to an emission of a source so as to form on said surface portion a layer having selected predetermined properties.

Another aspect of the present invention relates to an improved device in a system for the angled exposition of at least one surface portion of a substrate supported on a substrate holder to an emission of a source impinging obliquely on said surface portion, said device being provided for moving the substrate holder so as to improve the uniformity of the emission received on said surface portion.

Still another aspect of the present invention relates to semiconductor wafers having a multiplicity of laser mirror facets formed thereon parallel to each other and exposed to the emission of a source according to the method of the invention. In an alternative, the present invention relates to semiconductor wafers having two sets of laser mirror facets, each set consisting of a multiplicity of facets formed on the wafer parallel to each other, the facets of the one and the other set also being parallel to each other and respectively facing each other and being exposed to the emission of a source independently of each other according to the method of the invention.

A variety of deposition and other related exposition methods and systems are known in the art to provide for movement of the substrate holder so as to improve uniformity, thickness etc. of the resulting surface layers on the exposed surfaces. Such known methods and systems have not been specifically developed with a view to perform angled exposition within a closed vessel, and they are not suitable therefor, in that they do not provide for maintaining the orientation of the substrate holder with respect to the source while the substrate holder is moved. Besides, they do not allow angled exposition to be performed differently on different surfaces of one and the same substrate.

Representative of this known art are the devices disclosed by: L. Nowakowski in IBM Technical Disclosure Bulletin Vol. 29, No. 4 (Sept. 1986) pp. 1805-6, in which the substrate is moved along an orbital path with a superposed planetary movement by means of a driving mechanism comprised of a stationary pinwheel and a sprocket engaging with and orbiting around the pinwheel; J.A.Horton and R.P.King in IBM Technical Disclosure Bulletin Vol. 21, No. 6 (Nov. 1978) pp. 2419-20, in which the substrate is moved along an orbital path with a superposed planetary movement by means of a driving mechanism having three revolving parts to provide for a simple relation between the respective angles of rotation in the orbital and planetary movement; and M.S.lee in IBM Technical Disclosure Bulletin Vol. 16, No. 9 (Feb. 1974) pp. 2865-8, who discusses the results obtainable with a system having three revolving parts geared in succession by order of decreasing radii.

None of this prior art is capable of providing a movement compatible somehow with the angled exposition of laser mirror surfaces of the type disclosed by K.Iga, Y.Mori and Y.Kotaki in Bull. P.M.E. (T.I.T.) No. 58 (Sept. 1986) pp. 17-19 [published by Research Laboratory of Precision Machinery and Electronics, Tokyo Institute of Technology] in respect of angled sputtering on each side of a groove etched in a semiconductor wafer. Thus, none of this prior art is capable of improving the uniformity of such angled exposition.

Accordingly, it is an object of the invention to provide an improved method for the angled exposition of at least one surface portion of a substrate to an emission of a source so as to form on said surface portion a layer having selected predetermined properties, wherein said surface portion of the substrate is continuously exposed to said emission impinging obliquely on said surface portion, a substrate holder is provided for supporting the substrate and the substrate holder is moved together with the substrate supported thereon while said angled exposition is performed, so as to improve the uniformity of said properties of the formed layer.

A further object of the invention is to provide, in an system for the angled exposition of at least one surface portion of a substrate supported on a substrate holder to an emission of a source impinging obliquely on said surface portion, an improved device for moving the substrate holder so as to improve the uniformity of the emission received on said surface portion.

These objects and others, which will become apparent from the description which follows, are attained according to the invention by improving the aforesaid method in that the substrate holder is moved while its orientation with respect to the source is maintained. Preferably, the substrate holder is displaced in translation only while made to continuously follow a plane closed path, so that angled exposition is performed with the emission impinging on said at least one surface portion of the substrate in an essentially constant direction with respect to substrate-bound coordinates.

Also, the objects of the invention are attained in the aforesaid system by the provision of means for driving the substrate holder to displace it in translation only while making it continuously follow a plane closed path. Preferably, a device for moving the substrate holder in the aforesaid system is comprised of a first shaft supported at a base element of the angled exposition system and journalled for rotation therein, means for driving the first shaft in rotation, a supporting structure fixedly supported at the first shaft, a second shaft parallel to the first shaft, having the substrate holder affixed thereto, supported at the supporting structure and journalled for rotation therein, first wheel means supported at the base element of the angled exposition system coaxial to the first shaft, stop means to maintain the first wheel means in a predetermined angular position with respect to the base element, second wheel means fixedly supported at the second shaft coaxial thereto, and means for coupling together the first and second wheel means for imparting to the second shaft a rotation opposite to the rotation of the first shaft.

In one particular embodiment of the device, the first and second wheel means are gear-wheels having equal numbers of cogs, the means for coupling together the first and second gear-wheels is a third gear-wheel fixedly supported at a third shaft coaxial thereto, itself supported at the supporting structure and journalled for rotation therein, and the third gear-wheel is gearing with both the first and second gear-wheels.

In another embodiment of the device, the first and second wheel means are gear-wheels having respective first and second numbers of cogs, the means for coupling together the first and second gear-wheels is comprised of third and fourth gear-wheels having a respective third and fourth number of cogs, both the third and fourth gear-wheels being fixedly supported at a common third shaft coaxial thereto, itself supported at the supporting structure and journalled for rotation therein, the third gear-wheel is gearing with the first gear-wheel and the fourth gear-wheel is gearing with the second gear-wheel, and the ratio of the first number of cogs to the second number of cogs is equal to the ratio of the third number of cogs to the fourth number of cogs.

In still another embodiment of the device, the first and second wheel means are notched belt-pulleys having respective first and second notched grooves with equal respective numbers of notches, and the means for coupling together the first and second notched belt-pulleys is a notched belt supported at and gearing with both the first and second notched grooves.

In a further embodiment of the device, the first wheel means is supported for idler rotation at the base element of the angled exposition system, the stop means are comprised of an idler stop element arranged at the first wheel means in fixed relationship thereto and a fixed stop element arranged at the base element in fixed relationship thereto, and the idler stop element is adapted to abut the fixed stop element upon rotation of the first wheel means so as to stop the idler rotation thereof. Preferably, the idler stop element is adapted to abut the fixed stop element at two diametrically opposite angular positions of the first wheel means. The fixed stop element may be a peg affixed to the base element with its axis parallel to the first shaft, or the fixed stop element may be a peg affixed to a peg supporting element with its axis parallel to the first shaft, in which case the peg supporting element is supported at the base element and journalled for rotation therein coaxial to the first shaft at a distance of the peg, and adjusting means are provided for rotating the peg supporting element with respect to the base element to move the peg along an arc centered coaxial to the first shaft for adjustment of the orientation of the at least one surface portion of the substrate. Also, friction means may be provided to generate friction between first shaft and at least one of a group of elements comprised of the first wheel means, the idler stop element and means for fixing the idler stop element to the first wheel means, and the first wheel means may be supported at the base element by means of the first shaft.

The method according to the invention, preferably when implemented with the device according to the invention, allows to expose a surface to the emission of the source in such manner as to improve the homogeneity of the emission received on said surface while the direction from which the emission is received is maintained constant with respect to said surface.

The method according to the invention, preferably when implemented with the device according to the invention, also allows to expose two sets of surfaces in succession and independently of each other to the emission of a source within a closed vessel, e.g. for vacuum coating, ion etching, radiation polymerization etc. No access to or manipulation of the substrate or substrate holder being required between the two expositions performed in succession, there is no need to return the vessel to ambient atmosphere and conditions to allow for re-orienting the substrate with respect to the source.

Thus, the invention for instance allows to coat two sets of etched laser mirror surfaces on semiconductor wafers e.g. for passivation or modification of the reflectivity thereof. After the semiconductor substrate has been placed in the vacuum coating vessel, all mirrors of one set (e.g. all front mirrors) can be coated simultaneously and independently of all mirrors of the other set (e.g. of all rear mirrors) which are then coated simultaneously, too, without the vessel being reopened in-between. Upon reversal of the direction of rotation of the means for driving the substrate holder, the substrate is rotated by 180° to respectively expose one or the other set of mirrors to the emission of the source.

The invention will be described in closer detail in the following with reference to the accompanying drawings wherein:

Fig. 1 schematically illustrates a semiconductor wafer having facets to be exposed to the emission of a source according to the method of the invention;

Fig. 2 schematically illustrates the principle of a system for performing the method of the invention on surface portions of a substrate such as the semiconductor wafer illustrated in Fig. 1;

Fig. 3 is a schematic front view of a driving mechanism and of a stop means according to the invention in a device for moving a substrate holder so as to perform the method of the invention;

Fig. 4 is a schematic plan view of the driving mechanism and the stop means of Fig. 3;

Fig 5 is a schematic front view of another embodiment of the driving mechanism;

Fig. 6 is a schematic plan view of a modification of the driving mechanism of Fig. 5;

Fig. 7 is a schematic front view of still another embodiment of the driving mechanism;

Fig. 8 is a schematic front view of the driving mechanism of Fig. 3 combined with another embodiment of the stop means;

Fig 9 is a schematic plan view of the stop means of Fig. 8; and

Fig. 10 is a schematic front view of the driving mechanism of Fig. 3 combined with a variant of the embodiment of the stop means of Fig. 8.

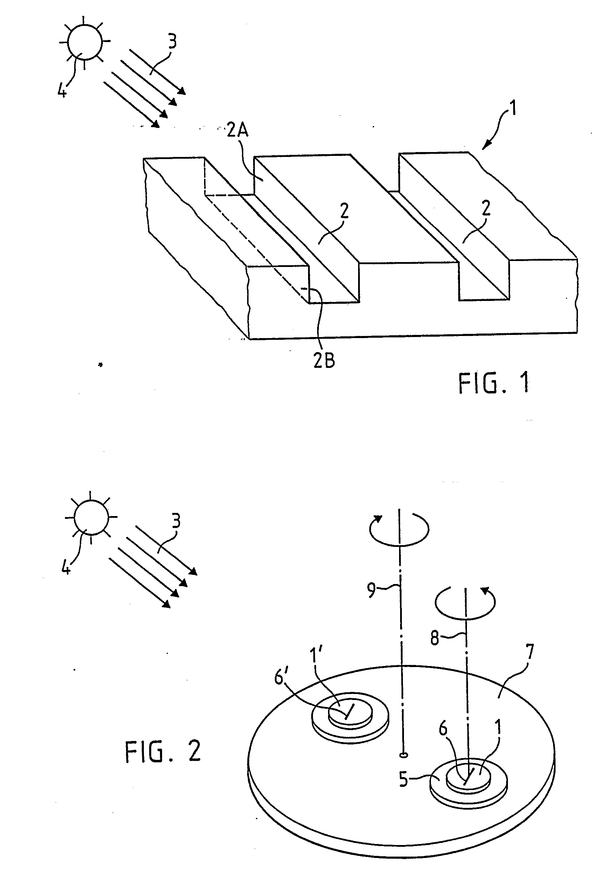

In Fig. 1 a substrate 1 consisting of a semiconductor wafer has a multiplicity of surface portions 2 formed thereon for instance by etching so as to constitute for instance laser mirror facets. These facets 2 are parallel to each other and form two sets 2A, 2B in such manner that all facets of set 2A are facing in one direction, all facets of set 2B are facing in the opposite direction, and the facets of the one and the other set are facing each other in pairs. As shown in Fig. 1, the facets of set 2A are exposed to the emission 3 of a source 4, for instance for coating facets 2A with a layer having selected predetermined properties such as a predetermined thickness and reflectivity. In order to form this coating, emission 3 impinges obliquely on the surface of facets 2A, and the distance between source 4 and substrate 1 is sufficient to ensure that all facets 2A are receiving emission 3 essentially under the same angle of for instance 45°.

However, in practice the emission of the source (in the illustrated instance the emitted stream of coating particles) is not uniform enough to result in a constant received stream on all facets 2A, and the distance between source 4 and surface portions 2 cannot be made large enough to result in a sufficiently constant receiving angle on all facets 2A. For these reasons, the substrate must be moved so as to improve the uniformity of the layer formed on such surface portions thereof which are exposed to the emission. This movement is subject to the condition that the orientation of the substrate with respect to the source is maintained, so that any variations of received intensity and receiving angle are averaged over various positions of the substrate, resulting in a constant average exposition of all facets 2A.

Furthermore, after the facets of the one set 2A have been exposed to emission 3 of source 4, it is usually desired to also expose the facets of the other set 2B to emission 3 of source 4 after having changed some conditions such as for instance the duration of the exposition. As a matter of illustration, when exposition is effected in a vacuum vessel for the purpose of coating laser mirror facets, it may be desired to coat the set of facets 2A with a fully reflecting layer and the set of facets 2B with a partly reflecting layer to allow for extraction of the laser beam from the semiconductor material, and in such case it is desirable that these coatings be performed in succession independently of each other and without breaking the vacuum for any reason such as re-orienting substrate 1. In other instances, the exposition may be effected for the purpose of etching by ion bombardment the exposed surface portions, or in order to cure or polymerize by radiation a layer provided thereon. In each such instance, exposition of the facets of set 2B is performed subsequent to the exposition of the facets of set 2A, and it is desired that these successive expositions be performed independently of each other in one single batch operation within a closed vessel which there is no need to return to ambient atmosphere and conditions e.g. to allow for re-orienting the substrate with respect to the source.

In Fig. 2 the principle of a system for performing the method of the invention is schematically illustrated. Substrate 1 is placed and supported on a substrate holder 5 and may be affixed thereto if need be. A longitudinal direction of facets 2 of Fig. 1 is marked as line 6 on substrate 1. Substrate holder 5 is placed in respect of source 4 so as to allow angled exposition of one set of facets 2 of Fig. 1, for instance facets 2A of Fig. 1, to emission 3 of source 4. Thus, a surface portion of substrate 1 consisting of facets 2A is continuously exposed emission 3, which impinges obliquely on facets 2A.

In the embodiment shown in Fig. 2, substrate holder 5 is formed as a horizontal disk and nested with play in a corresponding circular aperture of a horizontal baffle disk 7. It is stressed that the provision of baffle disk 7 is optional and serves to protect parts and means which will be described later against undesired exposition to the emission of the source. In the present description, baffle disk 7 serves illustration purposes only. Also, the horizontal disposition of the plane of substrate holder 5 is optional and serves illustration purposes only.

Substrate holder 5 has a vertical axis of rotation 8 and baffle disk 7 has a vertical axis of rotation 9. While angled exposition of substrate 1 to emission 3 is performed, baffle disk 7 is continuously rotated about its axis 9, so that axis 8 of substrate holder 5 is continuously moved around axis 9. Substrate 1 continuously accompanies this movement, its center continuously following a circular orbit around axis 9. Eventually, substrate 1 will reach some instant position referenced 1'.

According to the method of the invention, the movement of substrate holder 5 (and of substrate 1 supported thereon) is such that its orientation with respect to the source is maintained. In other words, the direction of mark line 6 remains constant, so that mark line 6 of substrate 1 is parallel to mark line 6' of any instant position 1' of substrate 1. In the case illustrated in Fig. 2, in view of performing angled exposition with the emission impinging on exposed surface portion 2 of substrate 1 in an essentially constant direction with respect to substrate-bound coordinates, substrate holder 5 and substrate 1 supported thereon are displaced in translation only while made to continuously follow a plane circular path. Means provided for driving substrate holder 5 to displace it in such manner will be described in the following.

Of course, the embodiment described with reference to Fig. 2 is applicable to the case where the source is located at a substantially greater distance from axis 9 than the distance from axis 8 to axis 9. In other words, this embodiment is applicable when an orthogonal projection of source 4 on the plane of baffle disk 7 is located radially outside any possible position 1' of substrate 1 in respect of axis 9 and preferably far outside baffle disk 7.

However, in case the source is located nearer to axis 9 than the distance from axis 8 to axis 9, i.e. when an orthogonal projection of source 4 on the plane of baffle disk 7 is located nearer to axis 9 than any possible position 1' of substrate 1, the teaching of the invention is still valid in that it prescribes to move the substrate holder while maintaining its orientation with respect to the source. In such case, substrate holder 5 and substrate 1 supported thereon are made to orbit around axis 9 in a manner similar to the moon orbiting around the earth.

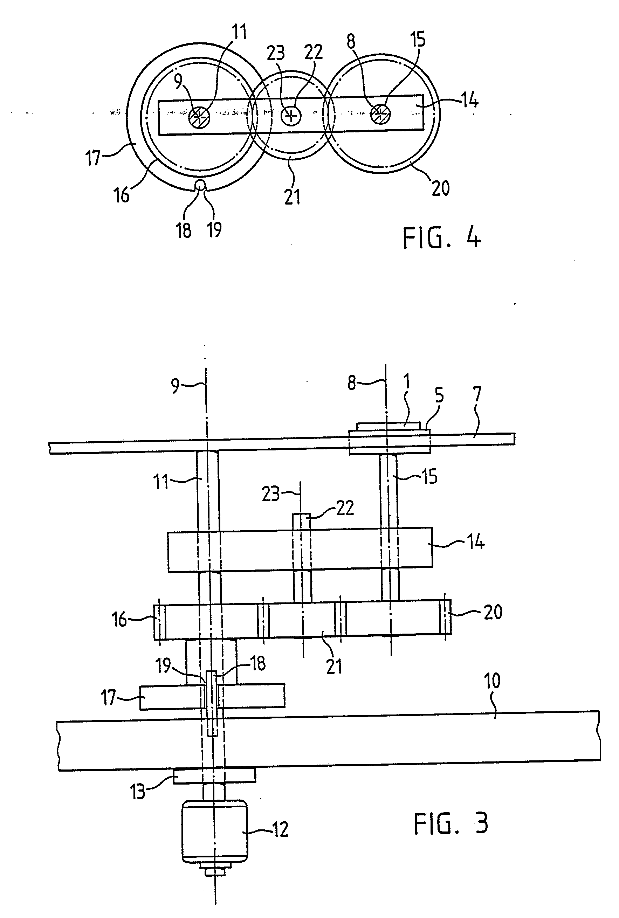

In a device improved according to the invention for moving a substrate holder so as to perform the method of the invention, an embodiment of a driving mechanism and a stop means according to the invention are illustrated in Figs. 3 and 4, whereby Fig. 3 shows a schematic front view and Fig. 4 a schematic plan view thereof. A base element 10 is provided to support the improved device now to be described e.g. within a closed vessel (not shown) in view of performing vacuum coating, ion etching, radiation polymerization or similar processes comprising angled exposition of the substrate. A first shaft 11 is supported at base element 10 and journalled for rotation therein. Shaft 11 may be driven in rotation by a driving means 12 such as an electric motor located outside the vessel e.g. at the outside end of shaft 11. In the instance described, base element 10 is formed as a flange mounted sealed at an aperture of the wall of the vessel and provided with a rotary seal 13 for shaft 11. Baffle disk 7 is supported at an inside end of shaft 11 coaxial thereto, whereby axis 9 of baffle disk 7 constitutes the axis of shaft 11, too.

A supporting structure 14 of for instance generally prismatic shape such as a beam is fixedly supported at shaft 11. A second shaft 15 is provided parallel to shaft 11 and spaced therefrom, supported at beam 14 and journalled for rotation therein in vicinity of one end of shaft 15. In vicinity of its other end, shaft 15 supports substrate holder 5 affixed coaxial thereto, whereby axis 8 of substrate holder 5 constitutes the axis of shaft 15, too.

Coaxial to shaft 11 there is provided a first wheel means formed as a first gear-wheel 16 supported at base element 10. Gear-wheel 16 can be fixed directly on base element 10. However, the embodiment illustrated provides, e.g. to facilitate mounting and dismounting operations for cleaning purposes, that gear-wheel 16 is journalled for rotation in shaft 11 and fixed in respect of base element 10 by stop means to maintain it in a predetermined angular position with respect to base element 10. In the embodiment illustrated, the stop means comprise a disk 17 coaxial to gear-wheel 16 and affixed thereto, and a peg 18 affixed to base element 10 and engaging disk 17 in a corresponding aperture 19 thereof. As disk 17 must rotate together with gear-wheel 16, idler rotation of disk 17 on shaft 11 is provided for, for instance in that disk 17 is axially spaced from or journalled for idler rotation in shaft 11.

At the end of second shaft 15 located in vicinity of beam 14 there is provided a second wheel means formed as a second gear-wheel 20 coaxial to and fixedly supported at shaft 15. Thus, substrate holder 8 and gear-wheel 20 are supported at and rotate together with shaft 15 in beam 14.

In this embodiment of Figs. 3 and 4, gear-wheels 16 and 20 have equal numbers of cogs.

To impart to shaft 15 a rotation of equal angular velocity but opposite to the rotation of shaft 11, there is provided a means for coupling together gear-wheels 16 and 20, formed as a third gear-wheel 21 fixedly supported in vicinity of one end of a third shaft 22 coaxial thereto. In vicinity of its other end, shaft 22 is supported at beam 14 and journalled for rotation therein about axis 23. Axis 23 is located in the plane of axes 8 and 9 and equidistant therefrom, and gear-wheel 21 is gearing with both gear-wheels 16 and 20.

When shaft 11 rotates in base element 10, gear-wheel 16 remains stationary due to peg 18 preventing disk 17 to rotate. However, beam 14 and the elements supported thereon rotate with shaft 11. Thus, gear-wheel 21 is moved around gear-wheel 16 in an orbiting movement, which movement imparts gear-wheel 21 a corresponding rotation about its axis 23. This rotation in its turn imparts a rotation to gear-wheel 20. It will be apparent that whether gear-wheel 21 has the same or a different numbers of cogs than gear-wheels 16 and 20, shaft 11 and gear-wheel 20 on shaft 15 will always rotate opposite to each other with equal angular velocity. Thus, shaft 15 is moved around shaft 11 in an orbiting movement comprised of translation only, resulting in the substrate holder 5 maintaining its orientation in space and particularly with respect to the source.

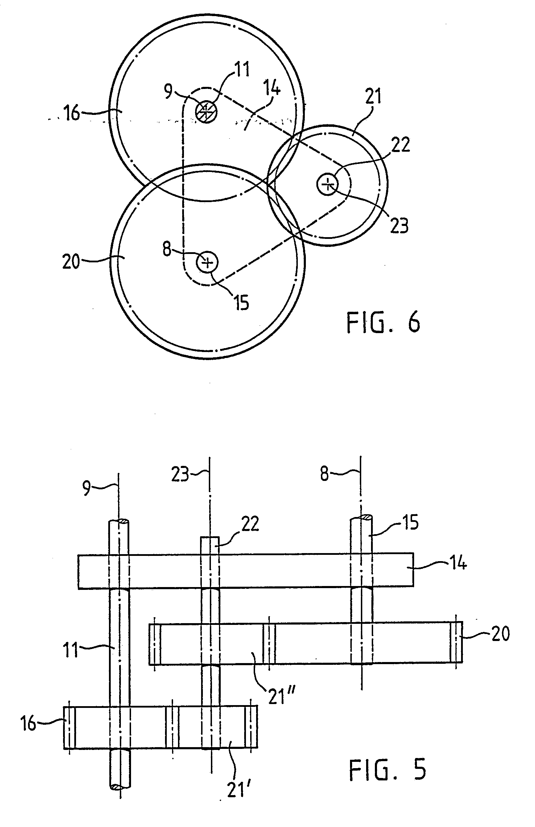

It will also be apparent that gear-wheels 16 and 20 need not be located opposite each other, they may be staggered as shown in Fig. 5. In this case, gear-wheel 21 is comprised of two parts 21′ and 21″ each coaxial to and fixedly supported at shaft 22. Actually, part 21′ is acting as a third gear-wheel gearing with first gear-wheel 16 and part 21″ is acting as a fourth gear-wheel gearing with the second gear-wheel 20. Both parts 21′ and 21″ are fixedly supported at their common third shaft 22 coaxial thereto, the latter being itself supported at the supporting structure 14 and journalled for rotation therein.

An advantage of placing gear-wheels 16 and 20 in such staggered arrangement is to allow the gear-wheels 16 and 20 to overlap each other, as shown in Fig. 6, resulting in the substrate holder 5 being placed nearer to its orbit axis 9 than in the case illustrated in Figs. 3 and 4.

In a particular embodiment, both parts 21′ and 21″ of gear-wheel 21 have equal numbers of cogs, so that they function together as the single gear-wheel 21 of Figs. 3 and 4. In a modification derived thereof and illustrated in Fig. 6, the two parts 21′ and 21″ are merged to a single gear-wheel 21 of sufficient axial length to allow it still to be in proper gearing engagement with both gear-wheels 16 and 20.

Another advantage of placing gear-wheels 16 and 20 in such staggered arrangement is to allow the gear-wheels 16 and 20 to be given different numbers of cogs. In this other particular embodiment, to impart to shaft 15 a rotation of equal angular velocity but opposite to the rotation of shaft 11, part 21′ (acting as the third gear-wheel) and part 21″ (acting as the fourth gear-wheel) each have a respective third and fourth number of cogs such that the ratio of the first number of cogs (of gear-wheel 16) to the second number of cogs (of gear-wheel 20) is equal to the ratio of the third number of cogs (of part 21′) to the fourth number of cogs (of part 21″).

It will be apparent that in embodiments equivalent to the aforesaid embodiments the gear-wheels and their gearing engagement may be substituted with friction wheels in respective friction engagement. Thus, in one alternative, the first and second wheel means may be friction wheels having equal diameters; in such case, the means for coupling together the first and second friction wheels is a third friction wheel fixedly supported at a third shaft coaxial thereto, itself supported at the supporting structure and journalled for rotation therein; and the third friction wheel is in friction engagement with both the first and second friction wheels. In another alternative, the first and second wheel means are friction wheels having respective first and second diameters; in such case, the means for coupling together the first and second friction wheels is comprised of third and fourth friction wheels having a respective third and fourth diameter, both the third and fourth friction wheels being fixedly supported at a common third shaft coaxial thereto, itself supported at the supporting structure and journalled for rotation therein; the third friction wheel is in friction engagement with the first gear-wheel and the fourth gear-wheel is gearing with the second gear-wheel; and the ratio of the first diameter to the second diameter is equal to the ratio of the third diameter to the fourth diameter.

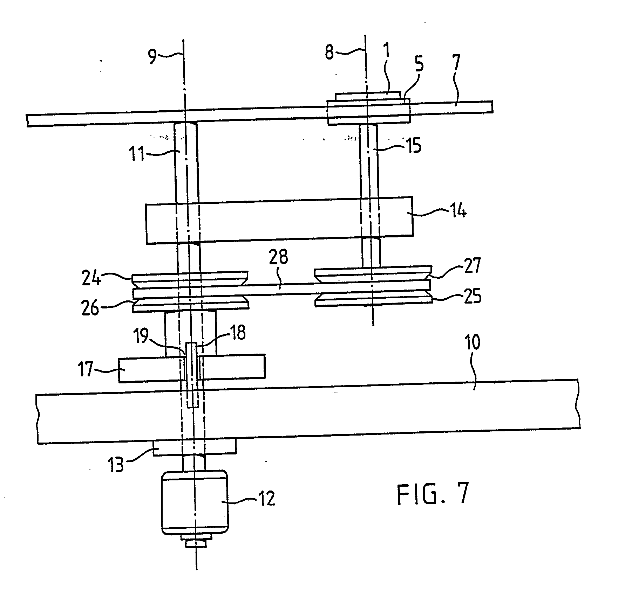

In a further embodiment schematically illustrated in Fig. 7, the first and second wheel means are formed as respective notched belt-pulleys 24, 25 each having a respective notched groove 26, 27. The means for coupling together notched belt-pulleys 24, 25 is a notched belt 28 supported at notched belt-pulleys 24, 25 gearing with the respective notched grooves 26, 27. To impart to shaft 15 a rotation of equal angular velocity but opposite to the rotation of shaft 11, the transmission ratio must be 1:1, i.e. notched grooves 26, 27 have equal numbers of notches.

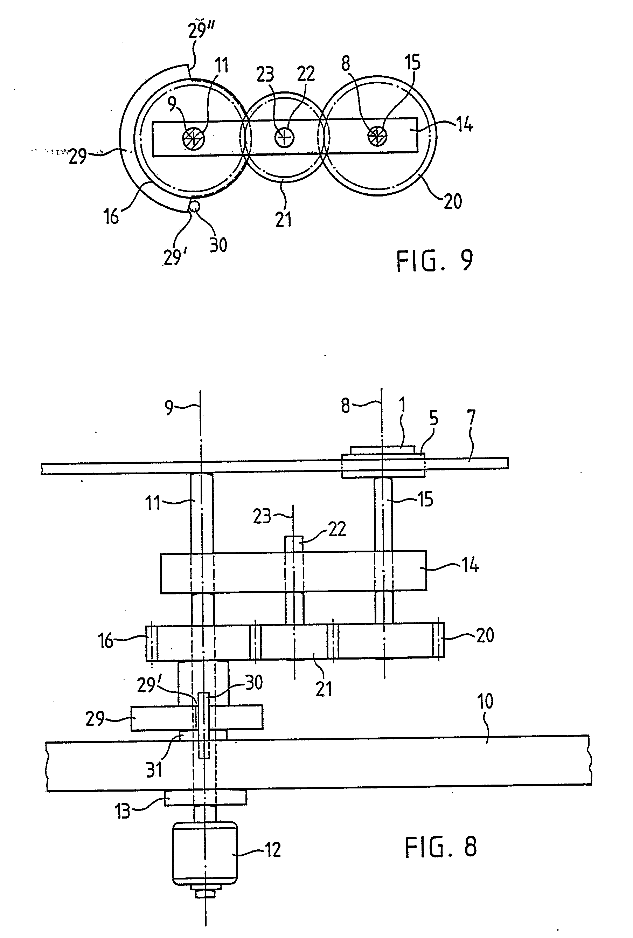

In connection with the embodiment of the stop means illustrated in Figs. 8 and 9 the first wheel means, for instance formed as gear-wheel 16, is supported for idler rotation at base element 10. The stop means are comprised of an idler stop element and a fixed stop element. The idler stop element is formed as a cam disk 29 arranged at gear-wheel 16 in fixed relationship thereto, for instance in a manner similar to the arrangement of disk 17 affixed to gear-wheel 16 in the embodiment of Figs. 3 and 4. The fixed stop element is formed as a peg 30 affixed to base element 10, for instance a cylindrical peg arranged with its axis parallel to axis 9 of shaft 11. Cam disk 29 has cam ramps 29', 29'' adapted to be abutted by peg 30 upon rotation of cam disk 29 so as to limit the idler rotation thereof between two abutment positions thereof. These two abutment positions correspond to two diametrically opposite angular positions of cam disk 29 and therefore of gear-wheel 16.

Between its two abutment positions, cam disk 29 is adapted to accompany in rotation the rotation of shaft 11. To attain this, the group of elements comprised of gear-wheel 16, cam disk 29 and the means (not shown) for fixing cam disk 29 to gear-wheel 16, can be supported at base element 10 by means of shaft 11. In such case the residual friction at the journal for idler rotation of this group of element will provide for the desired accompanying rotation. In an alternative illustrated in Fig. 8, a collar 31 is affixed at gear-wheel 16 to enclose shaft 11 coaxial thereto and provide controlled friction therewith. It would of course be equivalent to use as a friction means for instance a leaf spring affixed at gear-wheel 16 and arranged for friction engagement with shaft 11, and to affix said leaf spring at cam disk 29 or at the means (not shown) for fixing cam disk 29 to gear-wheel 16.

It will be apparent that when shaft 11 is rotated in one direction, cam disk 29 accompanies this rotation until it reaches the corresponding abutment position. During this rotation of cam disk 29, shaft 15 does not rotate about its own axis 8 because no relative movement is taking place between beam 14 and gear-wheel 16. Thus, substrate holder 5 is rotated by the same angle as shaft 11 until cam disk 29 reaches the corresponding abutment position. The same reasoning applies to the other direction of rotation of shaft 11. Thus, and provided that shaft 11 is rotated in succession in the one and the other direction by more than 180°, changing the sense of rotation of shaft 11 results in the orientation of substrate holder 5 being turned by 180°. By means of this feature the device improved according to the invention is capable of exposing to the emission of a source in succession and independently of each other the laser mirror facets of the one and the other set provided on a semiconductor wafer having two such sets of facets, each set consisting of a multiplicity of facets formed on the wafer parallel to each other, the facets of the one and the other set also being parallel to each other and respectively facing each other.

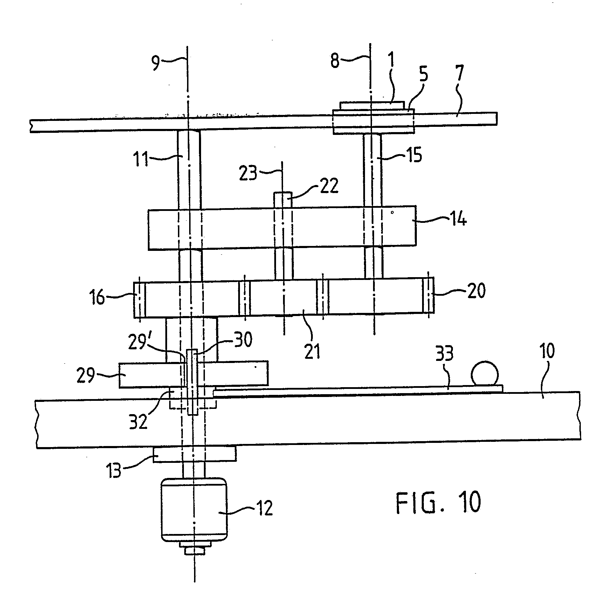

In a variant of this embodiment which is illustrated on Fig. 10, the fixed stop element again is formed as a peg 30, for instance a cylindrical peg which, however, is now affixed to a peg supporting element. This peg supporting element is for instance a peg carrier disk 32 itself supported at base element 10 and journalled for rotation therein coaxial to shaft 11. Peg 30 is arranged at peg carrier disk 32 with its axis parallel to and spaced from axis 9 of shaft 11. Adjusting means are provided, for instance in form of a lever 33, for rotating peg carrier disk 32 with respect to base element 10 to move peg 30 along an arc centered coaxial to axis 9 of shaft 11. Of course this adjusting means can be provided for remote operation, for instance mechanically through base element 10 or electrically by means of a motor located on base element 10. This feature allows for adjustment of the orientation of substrate holder 5 in any desired direction in addition to turning substrate holder 5 by 180° as described above.

The embodiments of the invention described in the foregoing are to be regarded as examples only and other embodiments are possible within the scope of the appended claims.

## Claims

1. An improved method for the angled exposition of at least one surface portion (2) of a substrate (1) to an emission (3) of a source (4) so as to form on said surface portion (2) a layer having selected predetermined properties, wherein
- said surface portion (2) of the substrate (1) is continuously exposed to said emission impinging obliquely on said surface portion (2);
- a substrate holder (5) is provided for supporting the substrate (1);
- the substrate holder (5) is moved together with the substrate (1) supported thereon while said angled exposition is performed, so as to improve the uniformity of said properties of the formed layer;
and wherein the improvement of the method comprises:
- moving the substrate holder (5) while maintaining its orientation with respect to the source (4).

2. The method of claim 1, wherein the substrate holder (5) is displaced in translation only while made to continuously follow a plane closed path, so that angled exposition is performed with the emission (3) impinging on said at least one surface portion (2) of the substrate (1) in an essentially constant direction with respect to substrate-bound coordinates.

3. In an system for the angled exposition of at least one surface portion (2) of a substrate (1) supported on a substrate holder (5) to an emission (3) of a source (4) impinging obliquely on said surface portion (2),

an improved device for moving the substrate holder (5) so as to improve the uniformity of the emission (3) received on said surface portion (2), comprising:
- means for driving the substrate holder (5) to displace it in translation only while making it continuously follow a plane closed path.

4. The device of claim 3, comprising:
- a first shaft (11) supported at a base element (10) of the angled exposition system and journalled for rotation therein;
- means (12) for driving the first shaft (11) in rotation;
- a supporting structure (14) fixedly supported at the first shaft (11);
- a second shaft (15) parallel to the first shaft (11), having the substrate holder (5) affixed thereto, supported at the supporting structure (14) and journalled for rotation therein;
- first wheel means (16,24) supported at the base element (10) of the angled exposition system coaxial to the first shaft (11);
- stop means (17,18;29,30) to maintain the first wheel means (16,24) in a predetermined angular position with respect to the base element (10);
- second wheel means (20,25) fixedly supported at the second shaft (15) coaxial thereto; and
- means (21,28) for coupling together the first (16,24) and second (20,25) wheel means for imparting to the second shaft (15) a rotation opposite to the rotation of the first shaft (11).

5. The device of claim 4, wherein
- the first (16) and second (20) wheel means are gear-wheels having equal numbers of cogs;
- the means for coupling together the first (16) and second (20) gear-wheels is a third gear-wheel (21) fixedly supported at a third shaft (22) coaxial thereto, itself supported at the supporting structure (14) and journalled for rotation therein; and
- the third gear-wheel (21) is gearing with both the first (16) and second (20) gear-wheels.

6. The device of claim 4, wherein
- the first (16) and second (20) wheel means are gear-wheels having respective first and second numbers of cogs;
- the means for coupling together the first (16) and second (20) gear-wheels is comprised of third (21') and fourth (21") gear-wheels having a respective third and fourth number of cogs, both the third (21') and fourth (21") gear-wheels being fixedly supported at a common third shaft (22) coaxial thereto, itself supported at the supporting structure (14) and journalled for rotation therein;
- the third gear-wheel (21') is gearing with the first gear-wheel (16) and the fourth gear-wheel (21") is gearing with the second gear-wheel (20); and
- the ratio of the first number of cogs to the second number of cogs is equal to the ratio of the third number of cogs to the fourth number of cogs.

7. The device of claim 4, wherein
- the first (24) and second (25) wheel means are notched belt-pulleys having respective first (26) and second (27) notched grooves with equal respective numbers of notches, and
- the means for coupling together the first (24) and second (25) notched belt-pulleys is a notched belt (28) supported at and gearing with both the first (26) and second (27) notched grooves.

8. The device of claim 4, wherein
- the first wheel means (16) is supported for idler rotation at the base element (10) of the angled exposition system;
- the stop means are comprised of an idler stop element (29) arranged at the first wheel means (16) in fixed relationship thereto and a fixed stop element (30) arranged at the base element (10) in fixed relationship thereto; and - the idler stop element (29) is adapted to abut the fixed stop element (30) upon rotation of the first wheel means (16) so as to stop the idler rotation thereof.

9. The device of claim 8, wherein the idler stop element (29) is adapted to abut the fixed stop element (30) at two diametrically opposite angular positions of the first wheel means (16).

10. The device of claim 9, wherein friction means (31) are provided to generate friction between the first shaft (11) and at least one of a group of elements comprised of the first wheel means (16), the idler stop element (29) and means for fixing the idler stop element (29) to the first wheel means (16).

11. The device of claim 9, wherein the first wheel means (16) is supported at the base element (10) by means of the first shaft (11).

12. The device of claim 9, wherein the fixed stop element (30) is a peg affixed to the base element (10) with its axis parallel to the first shaft (11).

13. The device of claim 9, wherein
- the fixed stop element (30) is a peg affixed to a peg supporting element (32) with its axis parallel to the first shaft (11),
- the peg supporting element (32) is supported at the base element (10) and journalled for rotation therein coaxial to the first shaft (11) at a distance of the peg (30), and
- adjusting means (33) are provided for rotating the peg supporting element (32) with respect to the base element (10) to move the peg (30) along an arc centered coaxial to the first shaft (11) for adjustment of the orientation of the at least one surface portion (2) of the substrate (1).

14. A semiconductor wafer having a multiplicity of laser mirror facets (2) formed thereon parallel to each other and exposed to the emission (3) of a source (4) according to the method of claim 1.

15. A semiconductor wafer having two sets (2A,2B) of laser mirror facets, each set consisting of a multiplicity of facets formed on the wafer parallel to each other, the facets of the one (2A) and the other (2B) set also being parallel to each other and respectively facing each other and being exposed to the emission (3) of a source (4) independently of each other according to the method of claim 1.

FIG. 1

FIG. 2

FIG. 4

FIG. 3

FIG. 6

FIG. 5

FIG. 7

FIG. 9

FIG. 8

FIG. 10

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | GB-A-2191335 (MITSUBISHI)<br>* the whole document * | 1, 3, 4, 15 | H01L21/00<br>H01J37/20 |
| A | FR-A-2298880 (COMMISARIAT A L'ENERGIE ATOMIQUE)<br>* page 4, line 1 - page 5, line 4; figures 1, 2 * | 1, 3 | |
| A | PATENT ABSTRACTS OF JAPAN<br>vol. 10, no. 168 (E-411)(2224) 14 June 1986,<br>& JP-A-61 18132 (TOSHIBA) 27 January 1986,<br>* see the whole document * | 1, 4 | |
| D,A | IBM TECHNICAL DISCLOSURE BULLETIN.<br>vol. 21, no. 6, November 1978, NEW YORK US<br>page 2419 - 2420; J.A. HORTON AND R.P. KING:<br>"PLANETARY ROTATION ETCHING WHEEL" | 1 | |
| D,A | IBM TECHNICAL DISCLOSURE BULLETIN.<br>vol. 29, no. 4, September 1986, NEW YORK US<br>page 1805 - 1806; NOWAKOWSKI:<br>"PLANETARY MOTION FIXTURE PLATE FOR THIN FILM DEPOSITION"<br>* the whole document * | 1, 3, 4 | TECHNICAL FIELDS SEARCHED (Int. Cl.5) |
| D,A | IBM TECHNICAL DISCLOSURE BULLETIN.<br>vol. 16, no. 9, February 1974, NEW YORK US<br>page 2865 - 2868; M.S. LEE:<br>"PLANETARY EVAPORATION SYSTEM HAVING MULTIPLE ROTATIONS" | 1 | H01L<br>H01J<br>C23C |

The present search report has been drawn up for all claims

| Place of search | Date of completion of the search | Examiner |
|---|---|---|
| THE HAGUE | 13 JUNE 1989 | RIEUTORT A.S. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
........................................................................
& : member of the same patent family, corresponding
   document